Europäisches Patentamt

European Patent Office

Office européen des brevets

(19)

(11) **EP 0 721 590 B1**

(12) **EUROPÄISCHE PATENTSCHRIFT**

(45) Veröffentlichungstag und Bekanntmachung des Hinweises auf die Patenterteilung:
**03.12.1997 Patentblatt 1997/49**

(21) Anmeldenummer: **94927477.3**

(22) Anmeldetag: **21.09.1994**

(51) Int Cl.⁶: **G01R 15/24**

(86) Internationale Anmeldenummer:
**PCT/DE94/01100**

(87) Internationale Veröffentlichungsnummer:
**WO 95/10045 (13.04.1995 Gazette 1995/16)**

(54) **VERFAHREN UND ANORDNUNG ZUM MESSEN EINES ELEKTRISCHEN STROMES MIT ZWEI GEGENLÄUFIGEN LICHTSIGNALEN UNTER AUSNUTZUNG DES FARADAY-EFFEKTS**

METHOD AND DEVICE FOR MEASURING AN ELECTRIC CURRENT USING TWO OPPOSITELY DIRECTED LIGHT SIGNALS AND MAKING USE OF THE FARADAY EFFECT

PROCEDE ET SYSTEME PERMETTANT DE MESURER UN COURANT ELECTRIQUE AU MOYEN DE DEUX SIGNAUX LUMINEUX OPPOSES, A L'AIDE DE L'EFFET FARADAY

(84) Benannte Vertragsstaaten:
**AT BE CH DE ES FR GB IT LI NL SE**

(30) Priorität: **01.10.1993 DE 4333538**
**07.07.1994 DE 4423981**

(43) Veröffentlichungstag der Anmeldung:
**17.07.1996 Patentblatt 1996/29**

(73) Patentinhaber: **SIEMENS AKTIENGESELLSCHAFT**
**80333 München (DE)**

(72) Erfinder:
* **BOSSELMANN, Thomas**
**D-91054 Erlangen (DE)**
* **MENKE, Peter**
**D-91054 Erlangen (DE)**

(56) Entgegenhaltungen:
**EP-A- 0 410 234          WO-A-92/13280**
**US-A- 5 063 290**

* **ALSTHOM REVIEW, Nr.9, Dezember 1987, PARIS FR Seiten 29 - 44 DUPRAZ 'FIBER-OPTIC INTERFEROMETERS FOR CURRENT MEASUREMENTS: PRINCIPLES...'**

EP 0 721 590 B1

# Beschreibung

Die Erfindung betrifft ein Verfahren und eine Anordnung zum Messen eines elektrischen Stromes in einem Stromleiter mit Hilfe eines dem Stromleiter zugeordneten Faraday-Elementes.

Es sind optische Meßanordnungen zum Messen eines elektrischen Stromes in einem Stromleiter unter Ausnutzung des Faraday-Effekts bekannt, die auch als magnetooptische Stromwandler bezeichnet werden. Unter dem Faraday-Effekt versteht man die Drehung der Polarisationsebene von linear polarisiertem Licht in Abhängigkeit von einem Magnetfeld. Der Drehwinkel ist dabei proportional zum Wegintegral über das Magnetfeld entlang des von dem Licht zurückgelegten Weges mit der sogenannten Verdet-Konstanten als Proportionalitätskonstante. Die Verdet-Konstante ist im allgemeinen material-, temperatur- und wellenlängenabhängig. Zum Messen des Stromes ist ein Faraday-Element aus einem optisch transparenten Material wie beispielsweise Glas in der Nähe des Stromleiters angeordnet. Das von dem Strom erzeugte Magnetfeld bewirkt eine Drehung der Polarisationsebene von durch das Faraday-Element gesendetem linear polarisiertem Licht um einen Drehwinkel, der als Meßsignal ausgewertet werden kann. Im allgemeinen umgibt das Faraday-Element den Stromleiter, so daß das Meßlicht den Stromleiter in einem geschlossenen Weg umläuft. Der Betrag des Drehwinkels ist in diesem Fall in guter Näherung direkt proportional zur Amplitude des zu messenden Stromes.

Das Faraday-Element kann als massiver Glasring um den Stromleiter ausgebildet sein (EP-B-0 088 419) oder auch den Stromleiter in Form einer Meßwicklung aus einer lichtleitenden Monomode-Faser umgeben (Faserspule).

Vorteile der magnetooptischen Stromwandler gegenüber herkömmlichen induktiven Stromwandlern sind ihre Potentialtrennung und Unempfindlichkeit gegenüber elektromagnetischen Störungen. Probleme bereiten bei dem Einsatz von magnetooptischen Stromwandlern jedoch ihre Temperatur- und Vibrationsempfindlichkeit.

Aus der WO 92/13280 ist eine Ausführungsform eines magnetooptischen Stromwandlers mit einer als Faraday-Meßwicklung um den Stromleiter ausgebildeten, optischen Faser bekannt. Bei dieser bekannten Ausführungsform werden durch Vorsehen einer optischen Faser mit einer hohen intrinsischen zirkularen Doppelbrechung ρ0 verglichen mit der Faraday-Drehung in Verbindung mit einer geeignet gewählten Signalverarbeitung Vibrationseinflüsse weitgehend kompensiert. Das Meßprinzip bei dieser bekannten Ausführungsform besteht darin, in die Faserspule zwei gegenläufige, linear polarisierte Lichtsignale S und T zu senden. Beide Lichtsignale S und T werden nach dem Durchlaufen des Faraday-Elements in zwei Lichtteilsignale S1 und S2 bzw. T1 und T2 mit zueinander orthogonalen Polarisationsebenen aufgeteilt, und diese Lichteilsignale S1 und S2 bzw. T1 und T2 werden mit Hilfe von Photodetektoren in entsprechende elektrische Intensitätssignale IS1 bzw. IS2 bzw. IT1 bzw. IT2 umgewandelt. Diese vier Intensitätssignale IS1 und IS2 und IT1 und IT2 werden durch Amplitudenquadrate dividiert, die der Gesamtintensität IS1 + IS2 bzw. IT1 + IT2 entsprechen, und damit intensitätsnormiert. Aus den vier intensitätsnormierten Signalen is1 bzw. is2 bzw. it1 bzw. it2 wird ein Meßsignal M abgeleitet, das gleich

$$M = ((is1 - is2) - (it1 - it2))/((is1 - is2) + (it1 - it2))$$

ist. Nun ist der Faraday-Effekt ein nicht-reziproker Effekt, so daß die beiden Lichtsignale S und T gegensinnig um denselben Faraday-Winkel p gedreht werden. Die lineare Doppelbrechung in dem Material der Faser ist hingegen ein reziproker Effekt und bewirkt daher die gleiche Modulation der beiden Lichtsignale S und T. Das mit diesem bekannten Verfahren gebildete Meßsignal M ist in guter Näherung gleich ρ/ρ0 und beinhaltet somit zwar noch die Informationen über die Faraday-Drehung p der beiden Lichtsignale S und T und damit den Meßstrom, die störenden linearen Doppelbrechungseffekte, insbesondere durch Vibrationen der Faser, werden jedoch praktisch vollständig eliminiert. Allerdings ist das Meßsignal M abhängig von der als Eichgröße verwendeten zirkularen Doppelbrechung ρ0 und damit wegen deren Abhängigkeit von der Temperatur selbst temperaturabhängig.

Eine weitere Ausführungsform ist aus US 5,063,290 bekannt. In dieser bekannten Anordnung wird als Lichtquelle eine mit einem vorgegebenen Trägersignal frequenzmodulierte Laserdiode verwendet. In der Anordnung sind ferner Mittel vorgesehen zur Umsetzung der Frequenzmodulation des Meßlichts in eine Polarisationsmodulation. Das polarisationsmodulierte Licht durchläuft eine Sensoreinrichtung, bestehend aus einer Faserspule mit extrem geringer Doppelbrechung, die sich im Magnetfeld eines zu messenden Stromes befindet. Das resultierende Lichtsignal wird in einer Signalverarbeitungseinheit zu einem elektrischen Signal gewandelt. Nach Demodulation mit der bekannten Ausgangsträgerfrequenz kann ein Meßsignal für den Strom I abgeleitet werden, dessen Phasenlage in eindeutiger Weise durch den zu messenden Strom bestimmt wird. Dieses Meßsignal ist weitgehend bereinigt von den Einflüssen linearer Doppelbrechung und insbesondere auch von der Temperaturdrift des Arbeitspunkts der Anordnung. Da bei diesem Verfahren aber die Information über die Temperatur in der Sensoreinrichtung verloren geht, kann die Temperaturabhängigkeit der Verdet-Konstanten bei diesem Verfahren nicht kompensiert werden.

Der Erfindung liegt deshalb die Aufgabe zugrunde, ein Verfahren und eine Anordnung zum Messen eines elektrischen Stromes unter Ausnutzung des Faraday-Effekts anzugeben, bei denen sowohl die Vibrations- als auch die Temperaturempfindlichkeit weitgehend unterdrückt werden.

Diese Aufgabe wird gemäß der Erfindung gelöst mit den Merkmalen der Ansprüche 1 oder 2 bzw. der Ansprüche 11 oder 12. Die Erfindung beruht dabei auf der Erkenntnis, daß durch Verwendung eines Faraday-Elements mit einer im Vergleich zur Faraday-Rotation vernachlässigbaren zirkularen Doppelbrechung und geeigneter signalverarbeitender Mittel ein Meßsignal erhalten werden kann, das sowohl von Vibrationen als auch von der Temperatur weitgehend unabhängig ist.

Vorteilhafte Ausgestaltungen des Meßverfahrens und der Meßanordnung ergeben sich aus den jeweils abhängigen Ansprüchen.

Zur weiteren Erläuterung der Erfindung wird auf die Zeichnung Bezug genommen, in deren

FIG. 1 ein prinzipieller Aufbau einer Anordnung zum Messen eines elektrischen Stromes und

FIG. 2 und 3 jeweils eine weitere Ausführungsform einer Anordnung zum Messen eines elektrischen Stromes mit einer besonderen Signalauswertung schematisch dargestellt sind. Einander entsprechende Teile sind mit denselben Bezugszeichen versehen.

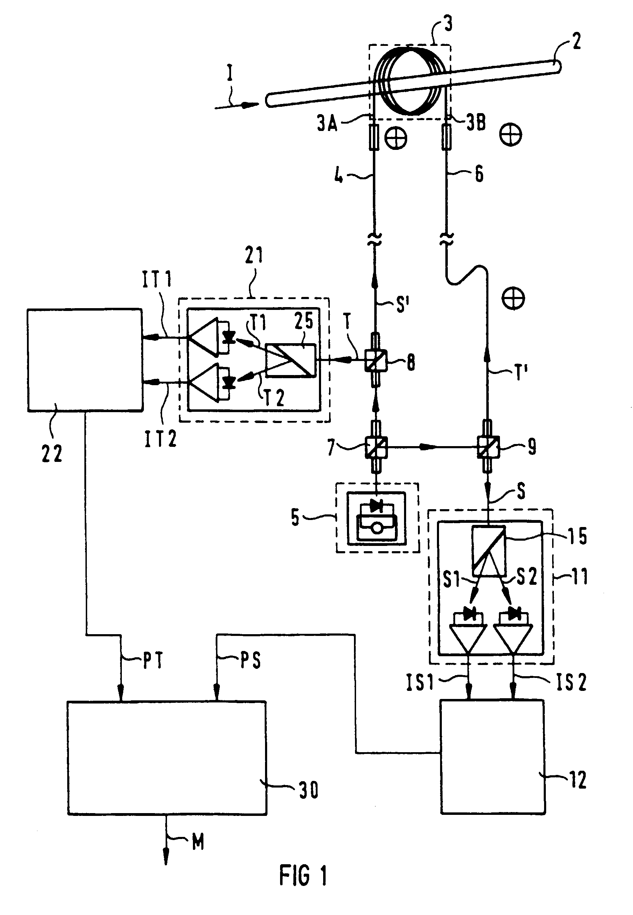

In der FIG. 1 sind ein Stromleiter mit 2, ein Faraday-Element mit 3, zwei Lichtwellenleiter als Übertragungsstrecken mit 4 und 6, eine linear polarisierte Lichtquelle mit 5, drei Strahlteiler als lichtteilende Mittel mit 7,8 und 9, zwei Wandlereinheiten mit 11 und 21, zwei Analysatoren mit 15 und 25, zwei Normierungseinheiten mit 12 und 22, und eine Signalverarbeitungseinheit mit 30 bezeichnet.

Linear polarisiertes Licht der Lichtquelle 5 wird in dem Strahlteiler 7 in zwei entsprechend polarisierte Lichtsignale S' und T' aufgeteilt, wobei das erste Lichtsignal S' durchgelassen und das zweite Lichtsignal T' abgelenkt wird. Das erste Lichtsignal S' durchläuft den nächsten Strahlteiler 8 und wird über den Lichtwellenleiter 4 in einen ersten Anschluß 3A des den Stromleiter 2 in Form einer Meßwicklung umgebenden Faraday-Elements 3 gesendet. Das zweite Lichtsignal T' wird in dem Strahlteiler 9 nochmals umgelenkt und über den Lichtwellenleiter 6 zu einem zweiten Anschluß 3B des Faraday-Elements 3 übertragen. Die beiden Lichtwellenleiter 4 und 6 sind dazu vorzugsweise polarisationserhaltend ausgebildet und können Mono-mode-Fasern wie beispielsweise eine HiBi-Faser oder polarisationsneutrale LoBi-Fasern sein. Den Anschlüssen 3A und 3B des Faraday-Elements 3 können als lösbare Verbindungen mit den Lichtwellenleitern 4 bzw. 6 nicht näher bezeichnete Spleiße zugeordnet sein. Die Lichtwellenleiter 4 und 6 sowie das Faraday-Element 3 können auch mit einem einzigen, durchgehenden Lichtwellenleiter gebildet sein. Außer einer Faserspule können als Faraday-Element auch ein massiver Glasring oder mehrere einzelne Glaskörper, die vorzugsweise einen geschlossenen Lichtpfad um den Stromleiter 2 bilden, vorgesehen sein. Schließlich muß das Faraday-Element den Stromleiter nicht ganz umgeben, sondern kann auch neben dem Stromleiter angeordnet sein.

Das Faraday-Element 3 ist nun so ausgebildet, daß es praktisch keine zirkulare Doppelbrechung im Vergleich zum Faraday-Effekt aufweist. Beispiele für ein solcherart ausgebildetes Faraday-Element 3 sind alle gängigen massiven Glaskörper, insbesondere Glasringe, oder auch getemperte Lichtfasern (Annealed-Fibre).

Die beiden Lichtsignale S' und T' durchlaufen in entgegengesetztem Umlaufsinn das Faraday-Element 3 und werden als nunmehr mit S und T bezeichnete Lichtsignale an den jeweils entgegengesetzten Anschlüssen 3B bzw. 3A ausgekoppelt. Bei diesem Umlauf werden die Polarisationsebenen der beiden Lichtsignale S' und T' durch das von einem Strom I in dem Stromleiter 2 erzeugte Magnetfeld gegensinnig um betragsmäßig gleiche Faraday-Meßwinkel $\rho$ bzw. $-\rho$ gedreht und erfahren zugleich dieselbe Modulation durch die lineare Doppelbrechung in dem Faraday-Element 3. Einflüsse durch zirkulare Doppelbrechung auf den Polarisationszustand der beiden Lichtsignale S' und T' sind durch die Wahl des Faraday-Elements 3 praktisch nicht vorhanden. Die in ihren Polarisationsebenen um den Meßwinkel $\rho$ bzw. $-\rho$ gedrehten Lichtsignale S und T werden nun über die Lichtwellenleiter 6 bzw. 4 zu den Strahlteilern 9 bzw. 8 übertragen. Das Lichtsignal S wird in dem Strahlteiler 9 durchgelassen und der Wandlereinheit 11 zugeführt. Das Lichtsignal T wird in dem Strahlteiler 8 umgelenkt und der Wandlereinheit 21 zugeführt. Somit durchlaufen beide Lichtsignale S' bzw. S und T' bzw. T jeweils einmal jeden der beiden Strahlteiler 8 und 9, so daß die in den Strahlteilern 8 und 9 eingebüßten Intensitätsverluste für beide Lichtsignale S und T wenigstens annähernd gleich sind.

Die Lichtquelle 5 und die Strahlteiler 7, 8 und 9 bilden zusammen mit den Lichtwellenleitern 4 und 6 oder - alternativ dazu - entsprechenden Freistrahlübertragungsstrecken Mittel zum Senden von zwei gegenläufigen, linear polarisierten Lichtsignalen S' und T' durch das Faraday-Element 3, deren Polarisationsebenen nach dem Durchlaufen des Faraday-Elements 3 aufgrund des Faraday-Effekts gegensinnig jeweils um einen Meßwinkel $\rho$ bzw. $-\rho$ gedreht sind.

In jeder Wandlereinheit 11 und 21 wird das entsprechende Lichtsignal S bzw. T mit Hilfe des jeweiligen Analysators 15 bzw. 25 in zwei Lichtteilsignale S1 und S2 bzw. T1 und T2 mit voneinander verschiedenen Polarisationsebenen aufgeteilt. Vorzugsweise sind diese beiden Polarisationsebenen zumindest annähernd senkrecht zueinander gerichtet. Als Analysatoren 15 und 25 können polarisierende Strahlteiler wie beispielsweise Wollaston-Prismen oder auch zwei um einen entsprechenden Winkel gekreuzte Polarisationsfilter mit einem Strahlteiler vorgesehen sein. In nicht näher bezeichneten photoelektrischen Wandlern wie beispielsweise in Verstärkerkreise geschalteten Photodioden werden die Lichtteilsignale S1 und S2 sowie T1 und T2 in entsprechende elektrische Intensitätssignale IS1 bzw. IS2 bzw. IT1 bzw. IT2 umgewandelt. Die Übertragung der Lichtteilsignale S1 und S2 sowie T1 und T2 von den Analysatoren 15 bzw. 25 zu den photoelektrischen Wandlern kann über eine Freistrahlanordnung oder entsprechende Lichtwellenleiter erfolgen. Die Wandlereinheiten 11 und 21 bilden zusammen Mittel zum Aufteilen jedes der beiden Lichtsignale S und T nach Durchlaufen des Faraday-Elements 3 in zwei Lichtteilsignale S1 und S2 bzw. T1 und T2 mit unterschiedlichen Polarisationsebenen und zum Umwandeln dieser Lichtteilsignale S1, S2, T1 und T2 in entsprechende elektrische Intensitätssignale IS1 bzw. IS2 bzw. IT1 bzw. IT2, die ein Maß für die Intensität des entsprechenden Lichtteilsignals sind.

Die Intensitätssignale IS1 und IS2 für das erste Lichtsignal S werden der Normierungseinheit 12 und die Intensitätssignale IT1 und IT2 des zweiten Lichtssignals T der Normierungseinheit 22 zugeführt. In den Normierungseinheiten 12 und 22 werden aus den Intensitätssignalen IS1 und IS2 bzw. IT1 und IT2 jeweils ein intensitätsnormiertes Signal PS bzw. PT erzeugt.

Diese intensitätsnormierten Signale PS und PT sind derart zu bilden, daß sie unabhängig von Intensitätsschwankungen in den beiden Lichtsignalen S und T und ihren Lichtteilsignalen S1 und S2 bzw. T1 und T2 sind, die beispielsweise durch Dämpfungsverluste in den Übertragungsstrecken oder Schwankungen der Lichtquelle 4 verursacht werden können.

Die intensitätsnormierten Signale PS und PT werden durch Division der Differenz durch die Summe der zugehörigen beiden Intensitätssignale IS1 und IS2 bzw. IT1 und IT2 gebildet, d.h.

$$PS = (IS1 - IS2)/(IS1 + IS2) \qquad (1a)$$

und

$$PT = (IT1 - IT2)/(IT1 + IT2). \qquad (1b)$$

Dazu sind in den Normierungseinheiten 12 und 22 vorzugsweise ein mit SUB1 bzw. SUB2 bezeichneter Subtrahierer zur Bildung des Differenzsignals IS1-IS2 bzw. IT1-IT2, ein mit ADD1 bzw. ADD2 bezeichneter Addierer zur Bildung des Summensignals IS1+IS2 bzw. IT1+IT2 und ein mit DIV1 bzw. DIV2 bezeichneter Dividierer zur Bildung des Quotientensignals (IS1 - IS2)/(IS1 + IS2) bzw. (IT1 - IT2)/(IT1 + IT2) aus dem Differenzsignal und dem Summensignal vorgesehen.

Die beiden intensitätsnormierten Signale PS und PT werden der Signalverarbeitungseinheit 30 zugeführt. Die Signalverarbeitungseinheit 30 leitet aus den intensitätsnormierten Signalen PS und PT ein Meßsignal M für den elektrischen Strom I im Stromleiter 2 ab, das sowohl vibrations- als auch temperaturkompensiert ist. Die Temperaturkompensation ist dabei wegen der vernachlässigbaren zirkularen Doppelbrechung im Faraday-Element 3 deutlich besser als bei beispielsweise der aus WO 92/13280 bekannten Anordnung.

In einer ersten, nicht dargestellten Ausführungsform wird das Meßsignal M aus den intensitätsnormierten Signalen PS und PT wie folgt abgeleitet. Zunächst werden zwei Signale PA = PS + PT und PB = PS - PT gebildet. Das so gebildete erste Signal PA ist im wesentlichen nur eine Funktion der linearen Doppelbrechung, nicht jedoch des Faraday-Drehwinkels $\rho$. Das zweite Signal PB ist hingegen im wesentlichen nur von der Faraday-Rotation $\rho$ abhängig. Das Meßsignal M läßt sich dann näherungsweise als Produkt einer Funktion f(PA) des ersten Signals PA mit dem zweiten Signal PB darstellen, d.h.

$$M = f(PA) \cdot PB.$$

Aus den Signalen PA und PB wird dann vorzugsweise durch Vergleich mit in einer vorab ermittelten Wertetabelle (look-up table) gespeicherten, geeichten Werten das Meßsignal M ermittelt. Die Wertetabelle kann numerisch berechnet oder experimentell ermittelt werden. Die Funktion f(PA) kann durch eine lineare oder quadratische Fit-Funktion angenähert werden, um die Zahl der benötigten Eichmessungen zu reduzieren. Es können natürlich auch direkt die beiden intensitätsnormierten Signale PS und PT selbst und eine entsprechende Wertetabelle zum Ableiten des Meßsignals M verwendet werden.

Um eine höhere Genauigkeit zu erreichen, kann das Meßsignal auch als allgemeine Funktion M = f(PA, PB) der beiden Signale PA und PB vorzugsweise wieder mit Hilfe einer Wertetabelle bestimmt werden. Ferner kann in allen Ausführungsformen anstelle einer Wertetabelle auch eine Eichfunktion verwendet werden.

In einer zweiten, alternativen Ausführungsform, bei der die intensitätsnormierten Signale PS und PT durch Division der Differenz durch die Summe der zugehörigen beiden Intensitätssignale IS1 und IS2 bzw. IT1 und IT2 gebildet werden, gemäß den Gleichungen (1a) und (1b), wird als Meßsignal M vorzugsweise der Quotient zweier linearer Funktionen der beiden intensitätsnormierten Signale PS und PT als Variablen herangezogen. Das Meßsignal M kann dann insbesondere durch die Beziehung

$$M = (a*PS-b*PT)/(c*PS+d*PT+e*E) \qquad (2)$$

mit reellen Koeffizienten a, b, c, d und e und einem Einheitssignal E erhalten werden. Das Einheitssignal **E** entspricht dabei betragsmäßig dem intensitätsnormierten Signal PS oder PT, wenn genau eines der beiden Intensitätssignale IS1 oder IS2 bzw. IT1 oder IT2 verschwindet.

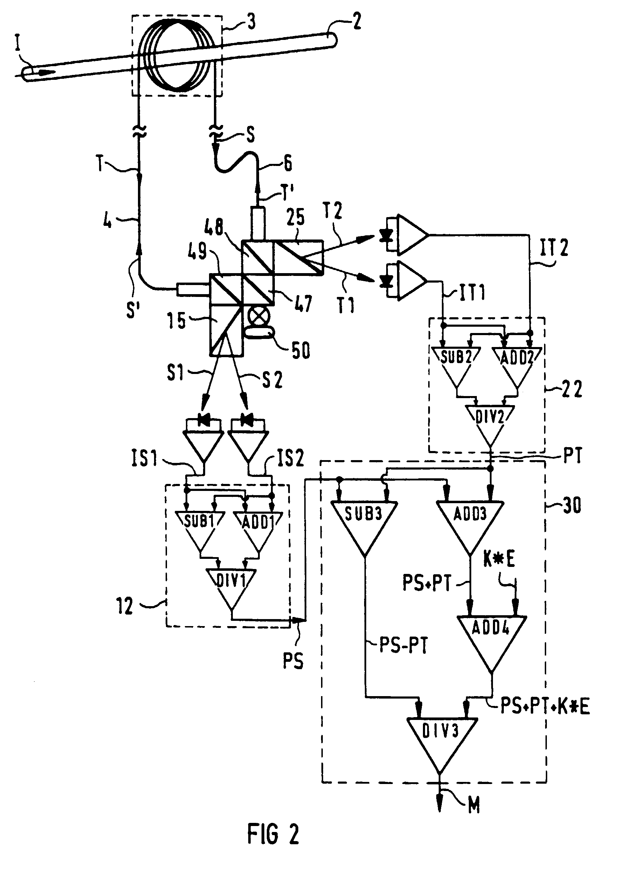

In der in FIG. 2 dargestellten Ausführungsform wird das Meßsignal M aus den beiden intensitätsnormierten Signalen PS und PT abgeleitet, indem der Quotient aus der Differenz PS-PT und der Summe PS+PT+K'·**E** gebildet wird, d.h.

$$M = (PS - PT)/(PS + PT + K' \cdot E) \qquad (3).$$

K' ist dabei ein vorgegebener, reeller Korrekturfaktor. **E** ist ein Einheitssignal, das dem Betrag des entsprechenden intensitätsnormierten Signale PS bzw. PT entspricht, wenn eines der beiden zugehörigen Intensitätssignale IS1 oder IS2 bzw. IT1 oder IT2 verschwindet. Dabei sind die Ausgangspegel der beiden Dividierer DIV1 und DIV2 der beiden Normierungseinheiten 12 und 22 entsprechend aufeinander abgestimmt, um dasselbe Einheitssignal **E** am Ausgang beider Dividierer DIV1 und DIV2 zu erhalten. Dieses Meßsignal M gemäß Gleichung (3) ergibt sich aus der allgemeinen Beziehung (2), indem man a=b=1 und c=d=1 sowie e=K' wählt.

Zum Ableiten dieses Meßsignals M gemäß Gleichung (3) sind in der Signalverarbeitungseinheit 30 vorzugsweise ein Subtrahierer SUB3 zum Ableiten des Differenzsignals PS-PT, ein erster Addierer ADD3 zum Bilden des Summensignals PS+PT, ein zweiter Addierer ADD4 zum Bilden des Summensignals PS+PT + K'***E** aus dem Summensignal PS+PT des ersten Addierers ADD1 und dem K'-fachen Einheitssignal K'***E** und ein Dividierer DIV3 zum Bilden des Quotientensignals (PS-PT)/(PS+PT+K'***E**) aus dem Differenzsignal PS-PT des Subtrahierers SUB3 und dem Summensignal PS+PT+K'***E** des zweiten Addierers ADD4 als Meßsignal M vorgesehen.

Durch Einstellen des Korrekturfaktors K' kann die Temperaturabhängigkeit des Meßsignals M zumindest annähernd eliminiert werden. Im allgemeinen liegt der Korrekturfaktor K' in einem Bereich zwischen -3 und 3.

In einer besonderen Ausführungsform werden der Korrekturfaktor K' und der Einkoppelwinkel η zwischen einer Eigenachse der linearen Doppelbrechung des Faraday-Elements 3 und der Polarisationsebene jedes in das Faraday-Element 3 eingekoppelten Lichtsignals S' und T' sowie der sogenannte Auskoppelwinkel θ zwischen dieser Eigenachse der linearen Doppelbrechung und einer Eigenachse des Analysators 15 bzw. 25 so eingestellt, daß sie wenigstens annähernd folgende Beziehungen erfüllen:

$$\sin(2\theta - 2\eta) = 1 \qquad (4a)$$

und

$$\cos(2\theta + 2\eta) = -K'/3. \qquad (4b)$$

Die Eigenachse eines doppelbrechenden Materials ist durch die Polarisationsrichtung bestimmt, unter der in das Material eingekoppeltes, linear polarisiertes Licht das Material bezüglich seiner Polarisation unverändert wieder verläßt.

Mögliche Winkelwerte zur Lösung dieser Gleichungen (4a) und (4b) sind beispielsweise η = 10,45° und θ = 55,45° für K'=2. Abweichungen von den die vorgenannten Beziehungen (4a) und (4b) exakt erfüllenden Winkelwerten sind insbesondere bei großer linearer Doppelbrechung im Faraday-Element 3 möglich und können bis zu etwa 5° betragen.

Rechnungen ergaben, daß bei derart in Abhängigkeit vom Korrekturfaktor K' gewählten Winkeln θ und η das Meßsignal

$$M \cong (2/K')*\sin(2\rho) \qquad (5)$$

ist und damit in guter Näherung seinem aus der Theorie zu erwartenden Wert sin(2ρ) ohne Doppelbrechungsanteile, skaliert mit 2/K', entspricht.

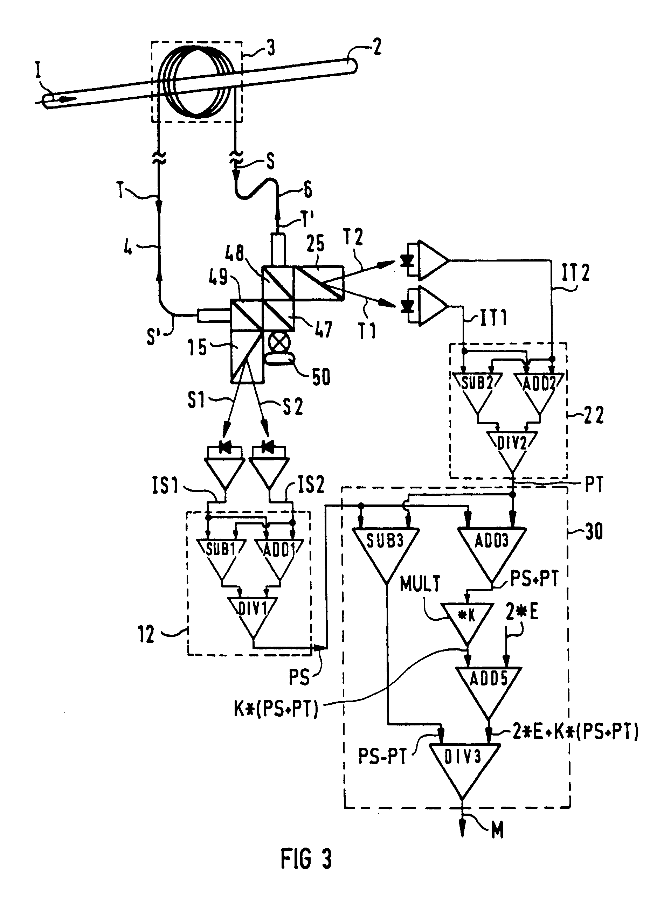

In FIG. 3 ist eine weitere, vorteilhafte Ausführungsform der Meßanordnung gezeigt. Ebenso wie in der Ausführungsform gemäß FIG. 2 werden auch in dieser Ausführungsform zunächst in den Normierungseinheiten 12 und 22 die intensitätsnormierten Signale PS und PT gemäß den Gleichungen (1a) und (1b) als Quotientensignale aus den Differenzen und den Summen der zugehörigen Intensitätssignale IS1 und IS2 bzw. IT1 und IT2 gebildet. Dazu sind vorzugsweise wieder jeweils ein Subtrahierer SUB1 bzw. SUB2, ein Addierer ADD1 bzw. ADD2 und ein Dividierer DIV1 bzw. DIV2 in den Normierungseinheiten 12 bzw. 22 vorgesehen.

In der Signalverarbeitungseinheit 30 werden wieder das Differenzsignal PS-PT mit Hilfe des Subtrahierers SUB3 und das Summensignal PS+PT mit Hilfe des Addierers ADD3 aus den beiden intensitätsnormierten Signalen PS und PT gebildet. Das am Ausgang des Addierers ADD3 anstehende Summensignal PS+PT wird dann einem Eingang eines Multiplizierers MULT zugeführt. Im Multiplizierers MULT wird das Eingangssignal mit einem vorgegebenen, reellen Korrekturfaktor K multipliziert. Als Multiplizierer MULT kann ein Verstärker vorgesehen sein, dessen Verstärkungsfaktor auf den Korrekturwert K eingestellt wird. Das am Ausgang des Multiplizierers MULT zur Verfügung stehende, mit dem Korrekturfaktor K multiplizierte Summensignal K* (PS+PT) wird nun einem Eingang eines Addierers ADD5 zugeführt und von dem Addierer ADD5 mit einem mit dem Faktor 2 multiplizierten Einheitssignal 2***E** addiert. Das Einheitssignal **E** entspricht dabei betragsmäßig dem intensitätsnormierten Signal PS oder PT, wenn eines der beiden Intensitätssignale IS1 oder IS2 bzw. IT1 oder IT2 verschwindet. Der Ausgang des Subtrahierers SUB3 und der Ausgang des Addierers ADD4 sind jeweils mit einem Eingang eines Dividierers DIV3 verbunden. Der Dividierer DIV 3 erzeugt aus seinen beiden Eingangssignalen PS-PT und 2*E+K*(PS+PT) das Quotientensignal (PS-PT)/(2*E+K*(PS+PT)), das als Meßsignal M für den elektrischen Strom I in dem Stromleiter 2 herangezogen wird.

Die Signalverarbeitungseinheit 30 bildet daher Mittel zum Ableiten eines Meßsignals M aus den beiden intensitätsnormierten Signalen PS und PT, wobei das Meßsignal M als Quotientensignal

$$M = (PS-PT)/(K*(PS+PT)+2*E)) \qquad (6)$$

bestimmt wird. Dieses Meßsignal M ergibt sich als Spezialfall aus der allgemeinen Beziehung (2), wenn man a=b=1, c=d=K und e=2 setzt.

Der reelle Korrekturfaktor K wird vorzugsweise so eingestellt, daß die Temperaturabhängigkeit des Meßsignals M wenigstens annähernd minimal ist. Im allgemeinen liegt der Kehrwert des Korrekturfaktors K in einem Bereich zwischen -1,5 und 1,5.

In einer besonders vorteilhaften Ausführungsform wird der Korrekturfaktor K in Abhängigkeit von dem Einkoppelwinkel $\eta$ und dem Auskoppelwinkel $\theta$ so eingestellt, daß wenigstens annähernd folgende beiden Beziehungen erfüllt sind:

$$\sin(2 \cdot \theta - 2 \cdot \eta) = 1 \qquad (7a)$$

$$\cos(2 \cdot \theta + 2 \cdot \eta) = -2/(3 \cdot K). \qquad (7b)$$

Der Einkoppelwinkel $\eta$ ist dabei wieder definiert als Winkel zwischen der Polarisationsebene jedes der beiden in das Faraday-Element 3 eingekoppelten Lichtsignale S' und T' und einer Eigenachse der linearen Doppelbrechung im Faraday-Element 3, und der Auskoppelwinkel $\theta$ ist wieder definiert als Winkel zwischen dieser Eigenachse der linearen Doppelbrechung und einer Eigenachse des zum Aufteilen der Lichtsignale S und T in jeweils zwei Lichtteilsignale S1 und S2 bzw. T1 und T2 vorgesehenen Analysators 15 bzw. 25.

Bei solcherart eingestellten Korrekturfaktor K, Einkoppelwinkel $\eta$ und Auskoppelwinkel $\theta$ entspricht das Meßsignal M im wesentlichen seinem theoretischen Wert

$$M = \sin(2\rho) \qquad (8)$$

ohne Doppelbrechungsanteile und ohne Skalierung mit einem vom Korrekturfaktor K abhängigen Faktor. Die Meßanordnung läßt sich daher in dieser Ausführungsform besonders einfach auf minimale Temperaturdrift justieren, indem man den Korrekturfaktor K so einstellt, daß das am Ausgang der Signalverarbeitungseinheit 30 anstehende Meßsignal M dem theoretischen Signal sin2$\rho$ bei nicht vorhandener linearer Doppelbrechung entspricht. Mögliche Werte zum Erfüllen der genannten Bedingungen (7a) und (7b) sind zum Beispiel K=1, $\eta = 10,45°$ und $\theta = 55,45°$. Abweichungen von den die vorgenannten Beziehungen (7a) und (7b) exakt erfüllenden Winkelwerten sind insbesondere bei großer linearer Doppelbrechung im Faraday-Element 3 möglich und können bis zu etwa 5° betragen.

Die Mittel zum Senden der zwei gegenläufigen Lichtsignale S' und T' durch das Faraday-Element 3 enthalten in den in FIG. 2 und 3 gezeigten Ausführungsformen miniaturisierte Strahlteiler 47, 48 und 49, miniaturisierte Analysatoren 15 und 25 und eine zugeordnete Lichtquelle 50 sowie nicht näher bezeichnete Kollimatorlinsen (Grinlenses) zur optischen Kopplung der Strahlteiler 48 und 49 mit den zugeordneten Lichtwellenleitern 6 bzw. 4. Die einzelnen Komponenten 47, 48, 49, 15 und 25 dieser Strahlteilermittel sind vorzugsweise miteinander verklebt und bilden eine kompakte optische Einheit. Es können allerdings auch wieder diskrete optische Bauelemente wie in der Ausführungsform gemäß FIG. 1 vorgesehen sein.

Die in den FIG. 2 und 3 dargestellten Ausführungsformen der Normierungseinheiten 12 und 22 und der Signalverarbeitungseinheit 30 ermöglichen eine Intensitätsschwankungs- und Temperaturkompensation in Echtzeit, weil sie mit analogen Hardware-Komponenten realisierbar sind. Selbstverständlich kann das Meßsignal M jedoch auch digital berechnet werden.

**Patentansprüche**

1.  Verfahren zum Messen eines elektrischen Stromes (I) in einem Stromleiter (2), bei dem

    a) zwei gegenläufige, linear polarisierte Lichtsignale (S' und T') durch ein dem Stromleiter (2) zugeordnetes Faraday-Element (3) gesendet werden und die Polarisationsebenen dieser beiden Lichtsignale (S und T) nach dem Durchlaufen des Faraday-Elements (3) aufgrund des Faraday-Effekts gegensinnig jeweils um einen vom elektrischen Strom (I) abhängenden Meßwinkel ($\rho$ bzw. -$\rho$) gedreht sind,
    b) jedes der beiden Lichtsignale (S, T) nach dem Durchlaufen des Faraday-Elements (3) in zwei linear polarisierte Lichtteilsignale (S1 und S2, T1 und T2) mit unterschiedlichen Polarisationsebenen aufgeteilt wird,
    c) jedes dieser Lichtteilsignale (S1,S2,T1,T2) in ein entsprechendes elektrisches Intensitätssignal (IS1, IS2, IT1 IT2) umgewandelt wird,
    d) für jedes der beiden durch das Faraday-Element (3) gelaufenen Lichtsignale (S und T) ein intensitätsnormiertes Signal (PS bzw. PT) abgeleitet wird, das einem Quotienten ((IS1-IS2)/(IS1+IS2) oder (IT1-IT2)/(IT1+IT2)) aus einer Differenz (IS1-IS2 bzw. IT1-IT2) und der Summe (IS1+IS2 bzw. IT1+IT2) der beiden zugehörigen Intensitätssignale (IS1 und IS2 bzw. IT1 und IT2) entspricht,

e) ein Faraday-Element (3) mit einer im Vergleich zum Meßwinkel (ρ bzw. -ρ) vernachlässigbaren zirkularen Doppelbrechung verwendet wird,

f) aus den beiden intensitätsnormierten Signalen (PS und PT) ein weitgehend vibrations- und temperaturunabhängiges Meßsignal (M) für den elektrischen Strom (I) abgeleitet wird, das dem Quotienten aus zwei linearen Funktionen der beiden intensitätsnormierten Signale (PS, PT) entspricht.

2. Verfahren zum Messen eines elektrischen Stromes (I) in einem Stromleiter (2), bei dem

   a) zwei gegenläufige, linear polarisierte Lichtsignale (S' und T') durch ein dem Stromleiter (2) zugeordnetes Faraday-Element (3) gesendet werden und die Polarisationsebenen dieser beiden Lichtsignale (S und T) nach dem Durchlaufen des Faraday-Elements (3) aufgrund des Faraday-Effekts gegensinnig jeweils um einen vom elektrischen Strom (I) abhängenden Meßwinkel (ρ bzw. -ρ) gedreht sind,

   b) jedes der beiden Lichtsignale (S, T) nach dem Durchlaufen des Faraday-Elements (3) in zwei linear polarisierte Lichtteilsignale (S1 und S2, T1 und T2) mit unterschiedlichen Polarisationsebenen aufgeteilt wird,

   c) jedes dieser Lichtteilsignale (S1,S2,T1,T2) in ein entsprechendes elektrisches Intensitätssignal (IS1, IS2, IT1 IT2) umgewandelt wird,

   d) für jedes der beiden durch das Faraday-Element (3) gelaufenen Lichtsignale (S und T) ein intensitätsnormiertes Signal (PS bzw. PT) abgeleitet wird, das einem Quotienten ((IS1-IS2)/(IS1+IS2) oder (IT1-IT2)/(IT1+IT2)) aus einer Differenz (IS1-IS2 bzw. IT1-IT2) und der Summe (IS1+IS2 bzw. IT1+IT2) der beiden zugehörigen Intensitätssignale (IS1 und IS2 bzw. IT1 und IT2) entspricht,

   e) ein Faraday-Element (3) mit einer im Vergleich zum Meßwinkel (ρ bzw. -ρ) vernachlässigbaren zirkularen Doppelbrechung verwendet wird,

   f) aus den beiden intensitätsnormierten Signalen (PS und PT) ein weitgehend vibrations- und temperaturunabhängiges Meßsignal (M) für den elektrischen Strom (I) abgeleitet wird, das eine Funktion einer Differenz (PS-PT) der beiden intensitätsnormierten Signale (PS, PT), die vom elektrischen Strom (I) abhängt, und der Summe (PS+PT) der beiden intensitätsnormierten Signale (PS, PT), die im wesentlichen nur von der linearen Doppelbrechung im Faraday-element (3) abhängt, ist.

3. Verfahren nach Anspruch 1, bei dem das Meßsignal (M) dem Quotienten ((PS-PT)/(PS+PT+K'·E)) aus der Differenz (PS-PT) der beiden intensitätsnormierten Signale (PS und PT) und der Summe (PS+PT+K'·**E**) aus den beiden intensitätsnormierten Signalen (PS und PT) und einem mit einem Korrekturfaktor K' multiplizierten Einheitssignal (**E**) entspricht, wobei das Einheitssignal (**E**) betragsmäßig gleich demjenigen intensitätsnormierten Signal (PS oder PT) ist, das sich ergibt, wenn genau eines der beiden dem jeweiligen intensitätsnormierten Signal (PS bzw. PT) zugeordneten Intensitätssignale (IS1 oder IS2 bzw. IT1 oder IT2) verschwindet.

4. Verfahren nach Anspruch 3, bei dem der Korrekturfaktor K' so eingestellt wird, daß die Temperaturabhängigkeit des Meßsignals (M) minimal ist.

5. Verfahren nach Anspruch 4, bei dem der Korrekturfaktor K' und ein Einkoppelwinkel η der Polarisationsebene jedes der beiden Lichtsignale (S' und T') beim Einkoppeln in das Faraday-Element (3) zu einer Eigenachse der linearen Doppelbrechung im Faraday-Element (3) sowie ein Auskoppelwinkel θ zwischen dieser Eigenachse und einer Eigenachse eines zum Aufteilen der Lichtsignale (S und T) in ihre zwei Lichtteilsignale (S1 und S2 bzw. T1 und T2) jeweils vorgesehenen Analysators (15 bzw. 25) wenigstens annähernd gemäß folgenden Bedingungen eingestellt werden:

$$\sin(2\theta - 2\eta) = 1$$

$$\cos(2\theta + 2\eta) = -K'/3.$$

6. Verfahren nach Anspruch 1, bei dem das Meßsignal (M) dem Quotienten ((PS-PT)/(K*(PS+PT)+2***E**)) aus der Differenz (PS-PT) und der Summe (K*(PS+PT)+2***E**) aus der mit einem vorgegebenen Korrekturfaktor K multiplizierten Summe (K*(PS+PT)) der beiden intensitätsnormierten Signale (PS und PT) und einem mit dem Faktor 2 multiplizierten Einheitssignal (**E**) entspricht, wobei das Einheitssignal (**E**) betragsmäßig gleich demjenigen intensitätsnormierten Signal (PS oder PT) ist, das sich ergibt, wenn genau eines der beiden dem jeweiligen intensitätsnormierten Signal (PS bzw. PT) zugeordneten Intensitätssignale (IS1 oder IS2 bzw. IT1 oder IT2) verschwindet.

7. Verfahren nach Anspruch 6, bei dem der Korrekturfaktor K so eingestellt wird, daß die Temperaturabhängigkeit des Meßsignals (M) minimal ist.

8.  Verfahren nach Anspruch 7, bei dem der Korrekturfaktor K und ein Einkoppelwinkel η der Polarisationsebene jedes der beiden in das Faraday-Element (3) eingekoppelten Lichtsignale (S' und T') zu einer Eigenachse der linearen Doppelbrechung im Faraday-Element (3) sowie ein Auskoppelwinkel θ zwischen dieser Eigenachse und einer Eigenachse eines zum Aufteilen der Lichtsignale (S bzw. T) in ihre zwei Lichtteilsignale (S1 und S2 bzw. T1 und T2) jeweils vorgesehenen Analysators (15 bzw. 25) derart eingestellt werden, daß sie wenigstens annähernd folgende Bedingungen erfüllen:

$$\sin(2 \cdot \theta - 2 \cdot \eta) = 1$$

$$\cos(2 \cdot \theta + 2 \cdot \eta) = -2/(3 \cdot K).$$

9.  Verfahren nach Anspruch 2, bei dem das Meßsignal (M) aus den beiden intensitätsnormierten Signalen (PS und PT) mit Hilfe einer vorab ermittelten Wertetabelle oder Eichfunktion abgeleitet wird.

10. Anordnung zum Messen eines elektrischen Stromes (I) in einem Stromleiter (2) mit

    a) einem dem Stromleiter (2) zugeordneten Faraday-Element (3),
    b) Mitteln (5, 7, 8, 9 oder 47, 48, 49, 50) zum Senden von zwei gegenläufigen, linear polarisierten Lichtsignalen (S' und T') durch das Faraday-Element (3), deren Polarisationsebenen nach dem Durchlaufen des Faraday-Elements (3) aufgrund des Faraday-Effekts gegensinnig jeweils um einen vom elektrischen Strom (I) abhängenden Meßwinkel (ρ bzw.- ρ) gedreht sind,
    c) Mitteln (11, 21) zum Aufteilen jedes der beiden Lichtsignale (S und T) nach Durchlaufen des Faraday-Elements (3) in zwei linear polarisierte Lichtteilsignale (S1 und S2 bzw. T1 und T2) mit unterschiedlichen Polarisationsebenen und Umwandeln dieser Lichtteilsignale (S1, S2, T1, T2) in entsprechende elektrische Intensitätssignale (IS1 bzw. IS2 bzw. IT1 bzw. IT2) und
    d) Mitteln (12, 22) zum Ableiten jeweils eines intensitätsnormierten Signals (PS und PT) für jedes der beiden Lichtsignale (S und T), das einem Quotienten ((IS1-IS2)/(IS1+IS2) bzw. (IT1-IT2)/(IT1+IT2)) aus einer Differenz (IS1-IS2 bzw. IT1-IT2) und der Summe (IS1+IS2 bzw. IT1+IT2) der beiden zugehörigen Intensitätssignale (IS1 und IS2 bzw. IT1 und IT2) entspricht, wobei
    e) das Faraday-Element (3) eine im Vergleich zum Meßwinkel (ρ bzw. -ρ) vernachlässigbare zirkulare Doppelbrechung aufweist und
    f) Mittel (30) zum Ableiten eines weitgehend vibrations- und temperaturunabhängigen Meßsignals (M) für den elektrischen Strom (I) aus den beiden intensitätsnormierten Signalen (PS und PT) vorgesehen sind, wobei das Meßsignal (M) dem Quotienten aus zwei linearen Funktionen der beiden intensitätsnormierten Signale (PS, PT) entspricht.

11. Anordnung zum Messen eines elektrischen Stromes (I) in einem Stromleiter (2) mit

    a) einem dem Stromleiter (2) zugeordneten Faraday-Element (3),
    b) Mitteln (5, 7, 8, 9 oder 47, 48, 49, 50) zum Senden von zwei gegenläufigen, linear polarisierten Lichtsignalen (S' und T') durch das Faraday-Element (3), deren Polarisationsebenen nach dem Durchlaufen des Faraday-Elements (3) aufgrund des Faraday-Effekts gegensinnig jeweils um einen vom elektrischen Strom (I) abhängenden Meßwinkel (ρ bzw.- ρ) gedreht sind,
    c) Mitteln (11, 21) zum Aufteilen jedes der beiden Lichtsignale (S und T) nach Durchlaufen des Faraday-Elements (3) in zwei linear polarisierte Lichtteilsignale (S1 und S2 bzw. T1 und T2) mit unterschiedlichen Polarisationsebenen und Umwandeln dieser Lichtteilsignale (S1, S2, T1, T2) in entsprechende elektrische Intensitätssignale (IS1 bzw. IS2 bzw. IT1 bzw. IT2) und
    d) Mitteln (12, 22) zum Ableiten jeweils eines intensitätsnormierten Signals (PS und PT) für jedes der beiden Lichtsignale (S und T), das einem Quotienten ((IS1-IS2)/(IS1+IS2) bzw. (IT1-IT2)/(IT1+IT2)) aus einer Differenz (IS1-IS2 bzw. IT1-IT2) und der Summe (IS1+IS2 bzw. IT1+IT2) der beiden zugehörigen Intensitätssignale (IS1 und IS2 bzw. IT1 und IT2) entspricht, wobei
    e) das Faraday-Element (3) eine im Vergleich zum Meßwinkel (ρ bzw. -ρ) vernachlässigbare zirkulare Doppelbrechung aufweist und
    f) Mittel (30) zum Ableiten eines weitgehend vibrations- und temperaturunabhängigen Meßsignals (M) für den elektrischen Strom (I) aus den beiden intensitätsnormierten Signalen (PS und PT) vorgesehen sind, wobei das Meßsignal (M) eine Funktion einer Differenz (PS - PT) der beiden intensitätsnormieren Signale (PS, PT), die vom elektrischen Strom (I) abhängt, und der Summe (PS + PT) der beiden intensitätsnormierten Signale (PS, PT), die im wesentlichen nur von der linearen Doppelbrechung im Faraday-Element (3) abhängt, ist.

12. Anordnung nach Anspruch 10, bei der die Mittel (30) zum Ableiten des Meßsignals (M) derart ausgebildet sind, daß das Meßsignal (M) dem Quotienten ((PS-PT)/(K*(PS+PT)+2***E**)) aus der Differenz (PS-PT) der beiden intensitätsnormierten Signale (PS und PT) und der Summe (K*(PS+PT)+2***E**) der mit einem vorgegebenen Korrekturfaktor K multiplizierten Summe (K*(PS+PT)) der beiden intensitätsnormierten Signal (PS und PT) und einem doppelten Einheitssignal (2***E**) entspricht, wobei das Einheitssignal (**E**) betragsmäßig gleich demjenigen intensitätsnormierten Signal (PS oder PT) ist, das sich ergibt, wenn genau eines der beiden dem jeweiligen intensitätsnormierten Signale (PS bzw. PT) zugeordneten Intensitätssignale (IS1 oder IS2 bzw. IT1 oder IT2) verschwindet.

13. Anordnung nach Anspruch 12, bei der der Korrekturfaktor K so eingestellt ist, daß die Temperaturabhängigkeit des Meßsignals (M) minimal ist.

14. Anordnung nach Anspruch 13, bei der

a) zum Aufteilen jedes der beiden Lichtsignale (S und T) in die jeweils zwei Lichtteilsignale (S1 und S2 bzw. T1 und T2) jeweils ein Analysator (15 bzw. 25) vorgesehen ist,
b) der Korrekturfaktor K und ein Einkoppelwinkel η der Polarisationsebene jedes der beiden in das Faraday-Element (3) eingekoppelten Lichtsignale (S' und T') zu einer Eigenachse der linearen Doppelbrechung im Faraday-Element (3) sowie ein Auskoppelwinkel θ zwischen dieser Eigenachse und einer Eigenachse des Analysators (15 bzw. 25) derart eingestellt sind, daß sie wenigstens annähernd die folgenden Bedingungen erfüllen:

$$\sin(2 \cdot \theta - 2 \cdot \eta) = 1$$

und

$$\cos(2 \cdot \theta + 2 \cdot \eta) = -2/(3 \cdot K).$$

15. Anordnung nach Anspruch 10, bei der die Mittel (30) zum Ableiten des Meßsignals (M) derart ausgebildet sind, daß das Meßsignal (M) dem Quotienten ((PS-PT)/(PS+PT+K'·**E**)) aus der Differenz (PS-PT) der beiden intensitätsnormierten Signale (PS, PT) und der Summe (PS + PT + K'·**E**) aus den beiden intensitätsnormierten Signalen (PS, PT) und einem mit einem Korrekturfaktor K' multiplizierten Einheitssignal (**E**) entspricht, wobei das Einheitssignal (**E**) betragsmäßig gleich demjenigen intensitätsnormierten Signal (PS oder PT) ist, das sich ergibt, wenn genau eines der beiden dem jeweiligen intensitätsnormierten Signal (PS bzw. PT) zugeordneten Intensitätssignale (IS1 oder IS2 bzw. IT1 oder IT2) verschwindet.

16. Anordnung nach Anspruch 15, bei der

a) zum Aufteilen jedes der beiden Lichtsignale (S und T) in die jeweils zwei Lichtteilsignale (S1 und S2 bzw. T1 und T2) jeweils ein Analysator (15 bzw. 25) vorgesehen ist,
b) der Korrekturfaktor K und ein Einkoppelwinkel η der Polarisationsebene jedes der beiden in das Faraday-Element (3) eingekoppelten Lichtsignale (S' und T') zu einer Eigenachse der linearen Doppelbrechung im Faraday-Element (3) sowie ein Auskoppelwinkel θ zwischen dieser Eigenachse und einer Eigenachse des Analysators (15 bzw. 25) derart eingestellt sind, daß sie wenigstens annähernd die folgenden Bedingungen erfüllen:

$$\sin(2 \cdot \theta - 2 \cdot \eta) = 1$$

und

$$\cos(2 \cdot \theta + 2 \cdot \eta) = -K'/3.$$

**Claims**

1. Method for measuring an electric current (I) in a current conductor (2), in which

a) two linearly polarized light signals (S' and T'), which propagate in opposite directions, are transmitted through a Faraday element (3) assigned to the current conductor (2) and the planes of polarization of these two light signals (S and T), after the transmission through the Faraday element (3), are by virtue of the Faraday effect rotated in opposite directions of rotation through measuring angles (ρ and -ρ) dependent on the electric current (I),
(b) each of these two light signals (S and T), after transmission through the Faraday element (3), is split into two linearly polarized partial light signals (S1 and S2, T1 and T2) having different planes of polarization,
(c) each of these partial light signals (S1, S2, T1, T2) is converted into a corresponding electric intensity signal (IS1, IS2, IT1, IT2),
(d) an intensity-normalized signal (PS or PT) is derived for each of the two light signals (S and T) transmitted through the Faraday element (3), which corresponds to a quotient ((IS1-IS2)/(IS1+IS2) or (IT1-IT2)/(IT1+IT2)) from a difference (IS1-IS2 or IT1-IT2) and the sum (IS1+IS2 or IT1+IT2) of the two associated intensity signals (IS1 and IS2 or IT1 and IT2),

e) a Faraday element (3) having a circular birefringence negligible in comparison with the measuring angle ($\rho$ or -$\rho$) is used,

f) a largely vibration- and temperature-independent measured signal (M) is derived for the electric current (I) from the two intensity-normalized signals (PS and PT), which corresponds to the quotient from two linear functions of the two intensity-normalized signals (PS, PT).

2. Method for measuring an electric current (I) in a current conductor (2), in which

a) two linearly polarized light signals (S' and T'), which propagate in opposite directions, are transmitted through a Faraday element (3) assigned to the current conductor (2) and the planes of polarization of these two light signals (S and T), after the transmission through the Faraday element (3), are by virtue of the Faraday effect rotated in opposite directions of rotation through measuring angles ($\rho$ or -$\rho$) dependent on the electric current (I),

(b) each of these two light signals (S and T), after transmission through the Faraday element (3), is split into two linearly polarized partial light signals (S1 and S2, T1 and T2) having different planes of polarization,

(c) each of these partial light signals (S1, S2, T1, T2) is converted into a corresponding electric intensity signal (IS1, IS2, IT1, IT2),

(d) an intensity-normalized signal (PS or PT) is derived for each of the two light signals (S and T) transmitted through the Faraday element (3), which corresponds to a quotient ((IS1-IS2)/(IS1+IS2) or (IT1-IT2)/(IT1+IT2)) from a difference (IS1-IS2 or IT1-IT2) and the sum (IS1+IS2 or IT1+IT2) of the two associated intensity signals (IS1 and IS2 or IT1 and IT2),

e) a Faraday element (3) having a circular birefringence negligible in comparison with the measuring angle ($\rho$ or -$\rho$) is used,

f) a largely vibration- and temperature-independent measured signal (M) is derived for the electric current (I) from the two intensity-normalized signals (PS and PT), which is a function of a difference (PS-PT) of the two intensity-normalized signals (PS, PT), which depends on the electric current (I), and the sum (PS+PT) of the two intensity-normalized signals (PS, PT), which depends essentially only on the linear birefringence in the Faraday element (3).

3. Method according to claim 1, in which the measured signal (M) corresponds to the quotient ((PS-PT)/ (PS+PT+K'·E)) from the difference (PS-PT) of the two intensity-normalized signals (PS and PT) and the sum (PS+PT+K'·E) from the two intensity-normalized signals (PS and PT) and a unity signal (E) multiplied by a correction factor K', wherein the unity signal (E) is equal in value to the intensity-normalized signal (PS or PT) which is obtained if precisely one of the two intensity signals (IS1 or IS2 or IT1 or IT2) assigned to the respective intensity-normalized signal (PS or PT) disappears.

4. Method according to claim 3, in which the correction factor K' is set in such a way that the temperature-dependence of the measured signal (M) is a minimum.

5. Method according to claim 4, in which the correction factor K' and an input coupling angle $\eta$ of the plane of polarization of each of the two light signals (S' and T') on coupling into the Faraday element (3) relative to an intrinsic axis of the linear birefringence in the Faraday element (3), as well as an output coupling angle $\theta$ between this intrinsic axis and an intrinsic axis of an analyser 15 or 25 provided for the subdividing of the respective light signals (S and T) into their two partial light signals (S1 and S2 or T1 and T2), are set at least approximately according to the following conditions:

$$\sin(2\theta - 2\eta) = 1$$

$$\cos(2\theta + 2\eta) = - K'/3 \, .$$

6. Method according to claim 1, in which the measured signal (M) corresponds to the quotient ((PS-PT)/(K* (PS+PT)+2*E)) from the difference (PS-PT) and the sum (K*(PS+PT)+2*E), from the sum multiplied by a pre-determined correction factor (K*(PS+PT)) of the two intensity-normalized signals (PS and PT) and a unity signal (E) multiplied by the factor 2, wherein the unity signal (E) is equal in value to that intensity-normalized signal (PS or PT) which results if precisely one of the two intensity signals (IS1 or IS2 or IT1 or IT2) assigned to the respective intensity-normalized signal (PS or PT) disappears.

7. Method according to claim 6, in which the correction factor K is set in such a way that the temperature-dependence of the measured signal (M) is minimal.

8. Method according to claim 7, in which the correction factor K and an input coupling angle $\eta$ of the plane of polarization of each of the two light signals (S' and T') coupled into the Faraday element (3) relative to an intrinsic axis of the linear birefringence in the Faraday element (3), as well as an output coupling angle θ between this intrinsic axis and an intrinsic axis of an analyser (15 or 25) provided for the subdividing of the respective light signals (S and T) into their two partial light signals (S1 and S2 or T1 and T2), are set so that they meet at least approximately the following conditions:

$$\sin (2{\cdot}\theta - 2{\cdot}\eta) = 1$$

$$\cos(2{\cdot}\theta + 2{\cdot}\eta) = - 2/(3{\cdot}K).$$

9. Method according to claim 2, in which the measured signal (M) is derived from the two intensity-normalized signals (PS and PT) with the aid of a previously determined table of values or calibration function.

10. Arrangement for measuring an electric current (I) in a current conductor (2) with

   a) a Faraday element (3) assigned to the current conductor (2),
   b) means (5, 7, 8, 9 or 47, 48, 49, 50) for the transmission of two linearly polarized light signals (S' and T'), which propagate in opposite directions, through the Faraday element (3), whose planes of polarization, after the transmission through the Faraday element (3), are by virtue of the Faraday effect rotated in opposite directions of rotation through a measuring angle (ρ and -ρ) dependent on the electric current (I),
   (c) means (11, 21) for splitting each of these two light signals (S and T), after transmission through the Faraday element (3), into two linearly polarized partial light signals (S1 and S2 or Ti and T2) having different planes of polarization and conversion of these partial light signals (S1, S2, T1, T2) into corresponding electric intensity signals (IS1 or IS2 or IT1 or IT2) and
   (d) means (12, 22) for deriving an intensity-normalized signal (PS or PT) for each of the two light signals (S and T), which corresponds to a quotient ((IS1-IS2)/(IS1+IS2) or (IT1-IT2)/(IT1+IT2)) from a difference (IS1-IS2 or IT1-IT2) and the sum (IS1+IS2 or IT1+IT2) of the two associated intensity signals (IS1 and IS2 or IT1 and IT2), wherein
   e) the Faraday element (3) has a circular birefringence negligible in comparison with the measuring angle (ρ or -ρ) and
   f) means (30) for deriving a largely vibration- and temperature-independent measured signal (M) for the electric current (I) from the two intensity-normalized signals (PS and PT) are provided, wherein the measured signal (M) corresponds to the quotient from two linear functions of the two intensity-normalized signals (PS, PT).

11. Arrangement for measuring an electric current (I) in a current conductor (2) with

   a) a Faraday element (3) assigned to the current conductor (2),
   b) means (5, 7, 8, 9 or 47, 48, 49, 50) for the transmission of two linearly polarized light signals (S' and T'), which propagate in opposite directions, through the Faraday element (3), whose planes of polarization, after the transmission through the Faraday element (3), are by virtue of the Faraday effect rotated in opposite directions of rotation through measuring angles (ρ and -ρ) dependent on the electric current (I),
   (c) means (11, 21) for splitting each of these two light signals (S and T), after transmission through the Faraday element (3), into two linearly polarized partial light signals (S1 and S2 or T1 and T2) having different planes of polarization and conversion of these partial light signals (S1, S2, T1, T2) into corresponding electric intensity signals (IS1 or IS2 or IT1 or IT2) and
   (d) means (12, 22) for deriving an intensity-normalized signal (PS or PT) for each of the two light signals (S and T), which corresponds to a quotient ((IS1-IS2)/(IS1+IS2) or (IT1-IT2)/(IT1+IT2))from a difference (IS1-IS2 or IT1-IT2) and the sum (IS1+IS2 or IT1+IT2) of the two associated intensity signals (IS1 and IS2 or IT1 and IT2), wherein
   e) the Faraday element (3) has a circular birefringence negligible in comparison with the measuring angle (ρ or -ρ) and
   f) means (30) for deriving a largely vibration- and temperature-independent measured signal (M) for the electric current (I) from the two intensity-normalized signals (PS and PT) are provided, wherein the measured signal (M) is a function of a difference (PS - PT) of the two intensity-normalized signals (PS, PT), which depends on the electric current (I), and the sum (PS + PT) of the two intensity-normalized signals (PS, PT), which depends essentially only on the linear birefringence in the Faraday element (3).

12. Arrangement according to claim 10, in which the means (30) for deriving the measured signal (M) are constructed in such a way that the measured signal (M) corresponds to the quotient ((PS-PT)/ (K* (PS+PT)+2*E)) from the difference (PS-PT) of the two intensity-normalized signals (PS and PT) and the sum (K*(PS+PT)+2*E) of the sum, multiplied by a pre-determined correction factor K, (K*(PS+PT)) of the two intensity-normalized signals (PS and PT) and twice a unity signal (2*E), wherein the unity signal (E) is equal in value to the intensity-normalized signal (PS or PT) which results if precisely one of the two intensity signals (IS1 or IS2 or IT1 or IT2) assigned to the respective intensity-normalized signal (PS or PT) disappears.

13. Arrangement according to claim 12, in which the correction factor K is set in such a way that the temperature-dependence of the measured signal (M) is minimal.

14. Arrangement according to claim 13, in which

a) for the subdividing of each of the two light signals (S and T) into the two respective partial light signals (S1 and S2 or T1 and T2), an analyzer (15 or 25) is provided in each case,
b) the correction factor K and an input coupling angle $\eta$ of the plane of polarization of each of the two light signals (S' and T') coupled into the Faraday element (3) relative to an intrinsic axis of the linear birefringence in the Faraday element 3, as well as an output coupling angle $\theta$ between this intrinsic axis and an intrinsic axis of the analyser (15 or 25) are set so that they at least approximately fulfil the following conditions:

$$\sin (2 \cdot \theta - 2 \cdot \eta) = 1$$

and

$$\cos(2 \cdot \theta + 2 \cdot \eta) = -2/(3 \cdot K).$$

15. Arrangement according to claim 10, in which the means (30) for deriving the measured signal (M) are constructed in such a way that the measured signal (M) corresponds to the quotient ((PS-PT)/(PS+PT+K'·E)) from the difference (PS-PT) of the two intensity-normalized signals (PS and PT) and the sum (PS + PT + K'·E) of the two intensity-normalized signals (PS, PT) and a unity signal (E) multiplied by a correction factor K', wherein the unity signal (E) is equal in value to that intensity-normalized signal (PS or PT) which results if precisely one of the two intensity signals (IS1 or IS2 or IT1 or IT2) assigned to the respective intensity-normalized signal (PS or PT) disappears.

16. Arrangement according to claim 15, in which

a) for the subdividing of each of the two light signals (S and T) into the two respective partial light signals (S1 and S2 or T1 and T2), an analyzer (15 or 25) is provided in each case,
b) the correction factor K and an input coupling angle $\eta$ of the plane of polarization of each of the two light signals (S' and T') coupled into the Faraday element (3) relative to an intrinsic axis of the linear birefringence in the Faraday element 3, as well as an output coupling angle $\theta$ between this intrinsic axis and an intrinsic axis of the analyser 15 or 25, are set so that they at least approximately fulfil the following conditions:

$$\sin(2 \cdot \theta - 2 \cdot \eta) = 1$$

and

$$\cos(2 \cdot \theta + 2 \cdot \eta) = -K'/3 .$$

## Revendications

1. Procédé pour mesurer un courant (I) électrique dans un conducteur (2), dans lequel

a) deux signaux (S', T') polarisés linéairement et opposés sont envoyés dans un élément de Faraday (3) associé au conducteur (2) et les plans de polarisation de ces deux signaux (S et T) lumineux sont, après la traversée de l'élément de Faraday (3), tournés chacun en sens inverse du fait de l'effet Faraday d'un angle ($\rho$ ou -$\rho$) de mesure dépendant du courant (I) électrique,
b) chacun des deux signaux (S, T) lumineux est, après avoir traversé l'élément de Faraday (3), divisé en deux signaux (S1 et S2, T1 et T2) lumineux partiels polarisés linéairement avec des plans de polarisation différents,
c) chacun de ces signaux (Si et S2, T1 et T2) lumineux partiels est converti en un signal (IS1, IS2, IT1, IT2) d'intensité électrique correspondant,
d) on dérive pour chacun des deux signaux (S et T) lumineux qui ont traversé l'élément de Faraday (3) un signal (PS et PT) à intensité normalisée qui correspond à un quotient ((IS1-IS2)/(IS1+IS2) ou (IT1-IT2)/(IT1+IT2)) d'une différence (IS1-IS2 ou IT1-IT2) et de la somme (IS1+IS2 ou IT1+IT2) des deux signaux (IS1 et IS2 et IT1 et IT2) d'intensité associés,
e) on utilise un élément de Faraday (3) présentant une biréfringence circulaire négligeable par rapport à l'angle ($\rho$ ou -$\rho$) de mesure,
f) on dérive des deux signaux (PS et PT) à intensité normalisée un signal (M) de mesure du courant (I) électrique, lequel signal est largement indépendant des vibrations et de la température et correspond au quotient de deux fonctions linéaires des deux signaux (PS, PT) à intensité normalisée.

2. Procédé pour mesurer un courant (I) électrique dans un conducteur (2), dans lequel

a) deux signaux (S', T') polarisés linéairement et opposés sont envoyés dans un élément de Faraday (3) associé au conducteur (2) et les plans de polarisation de ces deux signaux (S et T) lumineux sont, après la traversée de l'élément de Faraday (3), tournés chacun en sens inverse du fait de l'effet Faraday d'un angle (ρ ou -ρ) de mesure dépendant du courant (I) électrique,

b) chacun des deux signaux (S, T) lumineux est, après avoir traversé l'élément de Faraday (3), divisé en deux signaux (S1 et S2, T1 et T2) lumineux partiels polarisés linéairement avec des plans de polarisation différents,

c) chacun de ces signaux (S1 et S2, T1 et T2) lumineux partiels est converti en un signal (IS1, IS2, IT1, IT2) d'intensité électrique correspondant,

d) on dérive pour chacun des deux signaux (S et T) lumineux qui ont traversé l'élément de Faraday (3) un signal (PS et PT) à intensité normalisée qui correspond à un quotient ((IS1-IS2)/(IS1+IS2) ou (IT1-IT2)/(IT1+IT2)) d'une différence (IS1-IS2 ou IT1-IT2) et de la somme (IS1+IS2 ou IT1+IT2) des deux signaux (IS1 et IS2 et IT1 et IT2) d'intensité associés,

e) on utilise un élément de Faraday (3) présentant une biréfringence circulaire négligeable par rapport à l'angle (ρ ou -ρ) de mesure,

f) on dérive des deux signaux (PS et PT) à intensité normalisée un signal (M) de mesure du courant (I) électrique, lequel signal est largement indépendant des vibrations et de la température et est une fonction d'une différence (PS-PT) des deux signaux (PS, PT) à intensité normalisée qui dépend du courant (I) électrique et de la somme (PS+PT) des deux signaux (PS, PT) à intensité normalisée qui dépend pour l'essentiel uniquement de la biréfringence linéaire dans l'élément de Faraday (3).

3. Procédé selon la revendication 1, dans lequel le signal (M) de mesure correspond au quotient ((PS-PT) / (PS+PT+K'·**E**) de la différence (PS-PT) des deux signaux (PS et PT) à intensité normalisée et de la somme (PS+PT) des deux signaux (PS et PT) à intensité normalisée plus un signal (**E**) unité multiplié par un facteur K' de correction, la valeur du signal (**E**) unité étant égale à celle du signal (PS ou PT) à intensité normalisée qui est obtenu lorsque exactement l'un des deux signaux (IS1 ou IS2 et IT1 ou IT2) d'intensité associé au signal (PS ou PT) à intensité normalisée disparaît.

4. Procédé selon la revendication 3, dans lequel le facteur K' de correction est réglé de façon à ce que la variation avec la température du signal (M) de mesure soit minimale.

5. Procédé selon la revendication 4, dans lequel on règle le facteur K' de correction, un angle η d'entrée compris entre le plan de polarisation de chacun des deux signaux (S' et T') lumineux injectés dans l'élément de Faraday (3) et un axe propre de la biréfringence linéaire dans l'élément de Faraday (3) ainsi qu'un angle θ de sortie compris entre cet axe propre et un axe propre d'un analyseur (15 ou 25) prévu pour diviser les signaux (S et T) lumineux en deux signaux (S1 et S2 et T1 et T2) lumineux partiels, au moins approximativement suivant les conditions suivantes :

$$\sin(2\theta - 2\eta) = 1$$

$$\cos(2\theta + 2\eta) = -K'/3.$$

6. Procédé selon la revendication 1, dans lequel le signal (M) de mesure correspond au quotient ((PS-PT) / (K*(PS+PT)+2***E**)) de la différence (PS-PT) et de la somme (K*(PS+PT)+2***E**) formée de la somme (PS+PT) des deux signaux (PS et PT) à intensité normalisée multipliée par un facteur K de correction prédéterminé plus un signal (**E**) unité multiplié par le facteur 2, la valeur du signal (**E**) unité étant égale à celle du signal (PS ou PT) à intensité normalisée qui est obtenu lorsque exactement l'un des deux signaux (IS1 ou IS2 et IT1 ou IT2) d'intensité associé au signal (PS ou PT) à intensité normalisée disparaît.

7. Procédé selon la revendication 6, dans lequel le facteur K de correction est réglé de façon à ce que la variation avec la température du signal (M) de mesure soit minimale.

8. Procédé selon la revendication 7, dans lequel on règle le facteur K de correction et un angle η d'entrée compris entre le plan de polarisation de chacun des deux signaux (S' et T') lumineux injectés dans l'élément de Faraday (3) et un axe propre de la biréfringence linéaire dans l'élément de Faraday (3) ainsi qu'un angle θ de sortie entre cet axe propre et un axe propre d'un analyseur (15 ou 25) prévu pour diviser les signaux (S et T) lumineux en deux signaux (S1 et S2 et T1 et T2) lumineux partiels, de manière à ce qu'ils satisfassent au moins approxi-

mativement aux conditions suivantes :

$$\sin(2 \cdot \theta - 2 \cdot \eta) = 1$$

$$\cos(2 \cdot \theta + 2 \cdot \eta) = - 2/(3 \cdot K).$$

9. Procédé selon la revendication 2, dans lequel le signal (M) de mesure est dérivé des deux signaux (PS et PT) à intensité normalisée à l'aide d'une table de vérité ou d'une fonction étalon déterminée préalablement.

10. Dispositif pour mesurer un courant (I) électrique dans un conducteur (2) comprenant

    a) un élément de Faraday (3) associé au conducteur (2),
    b) des moyens (5, 7, 8, 9 ou 47, 48, 49, 50) pour envoyer dans l'élément de Faraday (3) deux signaux (S' et T') lumineux polarisés linéairement et opposés dont les plans de polarisation sont, après la traversée de l'élément de Faraday (3), tournés chacun en sens inverse du fait de l'effet Faraday d'un angle (ρ ou -ρ) de mesure dépendant du courant (I) électrique,
    c) des moyens (11, 21) pour diviser chacun des deux signaux (S et T) lumineux après la traversée de l'élément de Faraday (3) en deux signaux (S1 et S2 et T1 et T2) lumineux partiels polarisés linéairement et présentant des plans de polarisation différents et pour convertir ces signaux (S1, S2, T1, T2) lumineux partiels en signaux (IS1, et IS2 et IT1 et IT2) d'intensité électriques correspondants, et
    d) des moyens (12, 22) pour dériver un signal (PS et PT) à intensité normalisée pour chacun des deux signaux (S et T) lumineux, lequel signal correspond à un quotient ((IS1-IS2)/(IS1+IS2) ou (IT1-IT2)/(IT1+IT2)) d'une différence (IS1-IS2 ou IT1-IT2) et de la somme (IS1+IS2 ou IT1+IT2) des deux signaux (IS1 et IS2 et IT1 et IT2) d'intensité associés,
    e) l'élément de Faraday (3) présentant une biréfringence circulaire négligeable par rapport à l'angle (ρ ou -ρ) de mesure, et
    f) des moyens (30) pour dériver des deux signaux (PS et PT) à intensité normalisée un signal (M) de mesure du courant (I) électrique largement indépendant des vibrations et de la température, le signal (M) de mesure correspondant au quotient de deux fonctions linéaires des deux signaux (PS, PT) à intensité normalisée.

11. Dispositif de mesure d'un courant (I) électrique dans un conducteur (2), comprenant

    a) un élément de Faraday (3) associé au conducteur (2),
    b) des moyens (5, 7, 8, 9 ou 47, 48, 49, 50) pour envoyer dans l'élément de Faraday (3) deux signaux (S' et T') polarisés linéairement et opposés dont les plans de polarisation sont, après la traversée de l'élément de Faraday (3), tournés chacun en sens inverse du fait de l'effet Faraday d'un angle (ρ ou -ρ) de mesure dépendant du courant (I) électrique,
    c) des moyens (11, 21) pour diviser chacun des deux signaux (S et T) lumineux après la traversée de l'élément de Faraday (3) en deux signaux (S1 et S2 et T1 et T2) lumineux partiels polarisés linéairement et présentant des plans de polarisation différents et pour convertir ces signaux (S1, S2, T1, T2) lumineux partiels en signaux (IS1 et IS2 et IT1 et IT2) d'intensité électriques correspondants, et
    d) des moyens (12, 22) pour dériver un signal (PS et PT) à intensité normalisée pour chacun des deux signaux (S et T) lumineux, lequel signal correspond à un quotient ((IS1-IS2)/(IS1+IS2) ou (IT1-IT2)/(IT1+IT2)) d'une différence (IS1-IS2 ou IT1-IT2) et de la somme (IS1+IS2 ou IT1+IT2) des deux signaux (IS1 et IS2 et IT1 et IT2) d'intensité associés,
    e) l'élément de Faraday (3) présentant une biréfringence circulaire négligeable par rapport à l'angle (ρ ou -ρ) de mesure, et
    f) des moyens (30) pour dériver des deux signaux (PS et PT) à intensité normalisée un signal (M) de mesure du courant (I) électrique largement indépendant des vibrations et de la température, le signal (M) de mesure étant une fonction d'une différence (PS-PT) des deux signaux (PS, PT) à intensité normalisée qui dépend du courant (I) électrique et de la somme (PS+PT) des deux signaux (PS, PT) à intensité normalisée qui dépend pour l'essentiel uniquement de la biréfringence linéaire dans l'élément de Faraday (3).

12. Dispositif selon la revendication 10, dans lequel les moyens (30) pour dériver le signal (M) de mesure sont réalisés de telle manière que le signal (M) de mesure correspond au quotient ((PS-PT) / (K*(PS+PT)+2*E) de la différence (PS-PT) des deux signaux (PS, PT) à intensité normalisée et de la somme (K*(PS+PT)+2*E) formée de la somme (PS+PT)) des deux signaux (PS et PT) à intensité normalisée multipliée par un facteur K de correction prédéterminé plus un signal unité multiplié par 2 (2*E), la valeur du signal (E) unité étant égale à celle du signal (PS ou PT) à intensité normalisée qui est obtenu lorsque exactement l'un des deux signaux (IS1 ou IS2 et IT1 ou IT2) d'intensité associés aux signaux (PS ou PT) à intensité normalisée disparaît.

13. Dispositif selon la revendication 12, dans lequel le facteur K de correction est réglé de telle façon que la variation avec la température du signal (M) de mesure soit minimale.

14. Dispositif selon la revendication 13, dans lequel

    a) pour diviser chacun des deux signaux (S et T) lumineux en deux signaux (S1 et S2 et T1 et T2) lumineux partiels, il est prévu un analyseur (15 ou 25),
    b) on règle le facteur K de correction, un angle η d'entrée compris entre le plan de polarisation de chacun des deux signaux (S' et T') lumineux injectés dans l'élément de Faraday (3) et un axe propre de la biréfringence linéaire dans l'élément de Faraday (3) ainsi qu'un angle θ de sortie compris entre cet axe propre et un axe propre de l'analyseur (15 ou 25) de façon à ce qu'ils remplissent au moins approximativement les conditions suivantes :

$$\sin(2 \cdot \theta - 2 \cdot \eta) = 1$$

et

$$\cos(2 \cdot \theta + 2 \cdot \eta) = -2/(3 \cdot K).$$

15. Dispositif selon la revendication 10, dans lequel les moyens (30) pour dériver le signal (M) de mesure sont réalisés de telle manière que le signal (M) de mesuré correspond au quotient ((PS-PT)/(PS+PT)+K'·**E**) de la différence (PS-PT) des deux signaux (PS, PT) à intensité normalisée et de la somme (PS+PT) des deux signaux (PS et PT) à intensité normalisée plus un signal unité (**E**) multiplié par un facteur K' de correction, la valeur du signal (**E**) unité étant égale à celle du signal (PS ou PT) à intensité normalisée qui est obtenu lorsque exactement l'un des deux signaux (IS1 ou IS2 et IT1 ou IT2) d'intensité associés aux signaux (PS ou PT) à intensité normalisée disparaît.

16. Dispositif selon la revendication 15, dans lequel

    a) pour diviser chacun des deux signaux (S et T) lumineux en deux signaux (S1 et S2 et T1 et T2) lumineux partiels, il est prévu un analyseur (15 ou 25),
    b) on règle le facteur K de correction, un angle η d'entrée compris entre le plan de polarisation de chacun des deux signaux (S' et T') lumineux injectés dans l'élément de Faraday (3) et un axe propre de la biréfringence linéaire dans l'élément de Faraday (3) ainsi qu'un angle θ de sortie compris entre cet axe propre et un axe propre de l'analyseur (15 ou 25) de façon à ce qu'ils remplissent au moins approximativement les conditions suivantes :

$$\sin(2 \cdot \theta - 2 \cdot \eta) = 1$$

$$\cos(2 \cdot \theta + 2 \cdot \eta) = -K'/3.$$

FIG 1

FIG 2

FIG 3